# EUROPEAN PATENT APPLICATION

(11) **EP 4 822 378 A1**
(43) Date of publication of application: **14.10.2026**
(21) Application number: 25168834.7
(22) Date of filing: 07.04.2025
(51) Int. Cl.: G01R 33/24, G01R 33/56, G01R 33/48, G01R 33/561, G01R 33/563, G01R 33/565

(54) **WHOLE-BODY AMIDE PROTON TRANSFER WEIGHTED AND CHEMICAL EXCHANGE SATURATION TRANSFER MAGNETIC RESONANCE IMAGING**

(71) Applicant: Koninklijke Philips N.V., 5656 AE Eindhoven (NL)
(72) Inventor: KEUPP, Jochen, Eindhoven (NL); VAN DEN BRINK, Johan Samuel, Eindhoven (NL)
(74) Representative: Philips Intellectual Property & Standards

(57) **Abstract**

The present invention provides a method for performing whole-body, WB, amide proton transfer weighted/chemical exchange saturation transfer, APTw/CEST, magnetic resonance imaging, MRI, the method comprising the following method steps:
S1) B0 magnetic field shimming for B0 magnetic field homogenization and B1 radiofrequency field shimming for B1 radiofrequency field homogenization at multiple body positions and/or multiple imaging stations,
S2) measuring data including coil sensitivity, resonance frequency, B0 magnetic field maps, and B1 radiofrequency field maps at multiple body positions and/or multiple imaging stations,
S3) adapting a sequence operation protocol for the APTw/CEST locally at multiple body positions and/or multiple imaging stations, based at least in part on the measured data,
S4) acquiring APTw/CEST MRI data at multiple body positions and/or multiple imaging stations on the basis of the adapted sequence operation protocol,
S5) processing the acquired APTw/CEST MRI data for visualization, and
S6) visualizing the processed APTw/CEST MRI data.
In this way, a method is provided for performing whole-body APTw/CEST MRI that enables reliable, time-efficient, and spatially consistent imaging across multiple body regions.

## Description

### FIELD OF THE INVENTION

The invention relates to the field of whole-body amide proton transfer weighted and chemical exchange saturation transfer magnetic resonance imaging.

### BACKGROUND OF THE INVENTION

Magnetic resonance imaging (MRI) has become a cornerstone in modern diagnostic imaging, offering non-invasive, high-resolution visualization of anatomical and functional tissue characteristics. While conventional MRI techniques rely on differences in relaxation properties of hydrogen nuclei (T1, T2, proton density) to generate image contrast, advanced molecular MRI techniques have emerged in recent years that enable the detection of specific biochemical processes in vivo. One such technique is chemical exchange saturation transfer (CEST) MRI, which exploits the exchange of protons between certain metabolites and water to generate contrast that is sensitive to molecular content rather than just anatomical structures.

A particularly promising variant of CEST MRI is amide proton transfer weighted (APTw) MRI, which is increasingly being adopted in clinical research and practice. APTw MRI leverages the chemical exchange of amide protons in endogenous proteins and peptides with bulk water protons, a process that is sensitive to protein concentration, pH, and other microenvironmental conditions. This technique does not require exogenous contrast agents, which is a major advantage for longitudinal studies and applications in sensitive populations.

In clinical oncology, APTw MRI is gaining recognition as a non-invasive imaging biomarker for malignancy and genetic mutation status. Most prominently, it has been applied in brain imaging for the assessment of primary brain tumors such as gliomas. Numerous studies have shown that APTw signal intensity correlates with tumor grade, cellularity, and even IDH mutation status in gliomas, making it a valuable diagnostic and prognostic tool. Its ability to capture subtle biochemical changes in tissue composition has led to its increasing use in routine brain tumor imaging protocols.

Despite its success in neuro-oncology, the use of APTw MRI outside the brain remains limited. The technical challenges in implementing APTw imaging in extracranial regions are significant and include susceptibility to field inhomogeneities (both B0 and B1), respiratory and cardiac motion artifacts, and confounding fat signals. These factors can severely degrade image quality and quantification accuracy in regions such as the abdomen, pelvis, or extremities. Moreover, unlike the relatively homogeneous and motion-insensitive environment of the brain, extracranial imaging requires customized acquisition protocols and artifact mitigation strategies tailored to each anatomical region.

Nevertheless, recent clinical and preclinical studies have begun to demonstrate the potential utility of APTw MRI in other organs, including the prostate, breast, liver, and musculoskeletal system. In these applications, APTw imaging has shown promise in distinguishing malignant from benign lesions, evaluating treatment response, and providing functional information complementary to conventional MRI. This growing body of evidence supports the idea that, if technical limitations can be overcome, APTw MRI could become a powerful tool for whole-body oncological assessment.

To understand the challenges and opportunities of whole-body APTw imaging, it is important to briefly review the underlying principles of CEST and APTw MRI:
CEST is a technique that uses frequency-selective radiofrequency (RF) saturation pulses to label exchangeable protons in metabolites or other endogenous molecules. These labeled protons exchange with bulk water protons, resulting in a reduction in the water signal, which can be detected using standard MRI sequences. The degree of signal reduction depends on the concentration and exchange rate of the target protons, which in turn are influenced by the molecular environment (e.g., pH, temperature, and protein content).

Amide proton transfer (APT) imaging is a specific CEST technique that targets the amide protons (-NH molecular groups) of endogenous mobile proteins and peptides, which resonate approximately 3.5 ppm downfield from water. By applying RF saturation at this frequency, amide protons are selectively saturated, and their magnetization is transferred to water via chemical exchange. The result is a signal decrease in the water resonance that reflects the concentration and dynamics of cellular proteins, providing a surrogate measure of cellular proliferation and metabolic activity.

APTw imaging involves relatively long RF saturation durations (often in the order of 2 seconds per repetition time, TR), and the sequence must be carefully controlled to ensure adequate saturation, while avoiding excessive energy deposition (SAR). Additionally, Z-spectra (plots of signal intensity versus saturation frequency offset) are typically acquired to extract the APT effect, requiring either multiple frequency offsets or specialized acquisition schemes.

As currently implemented, APTw MRI is primarily applied in single body regions, with specific protocols adapted for that anatomical site. Each application demands careful adjustment of saturation power, pulse duration, offset frequency, and artifact correction methods. For example, in brain imaging, static B0 field inhomogeneities are addressed using B0 mapping and correction, while motion is typically negligible. In contrast, whole-body applications would require a method capable of accommodating varying tissue properties, motion characteristics, and magnetic field conditions across different regions.

Moreover, extracranial tissues often contain high concentrations of fat, which introduces additional off-resonance effects and artifacts in the z-spectrum, potentially confounding the quantification of APT signals. Techniques such as fat suppression, Dixon-based water/fat separation, or respective RF pulses are typically required to address this.

Motion also presents a major challenge. In regions affected by respiration (e.g., thorax, abdomen) or cardiac motion (e.g., heart, mediastinum), signal stability can be compromised. While breath-hold or gating techniques exist, they are not easily compatible with the prolonged acquisition times and continuous saturation required for APTw imaging.

Despite these limitations, the potential clinical value of whole-body APTw MRI is immense. In oncology, the ability to assess both primary tumors and metastatic spread in a single, non-invasive scan would be highly desirable. One specific disease that highlights this need is Neurofibromatosis (NF1 and NF2), a genetic disorder characterized by the growth of benign nerve sheath tumors throughout the body. In these patients, there is a risk of malignant peripheral nerve sheath tumor (MPNST) transformation, which can occur at any location. Current imaging strategies rely on conventional MRI or PET/CT to monitor these patients, but they often fail to provide early biochemical information about malignancy potential.

PET (positron emission tomography) is a medical imaging technique that shows how tissues, lesions like tumors and organs are functioning. It uses a small amount of radioactive material, called a tracer, which is usually injected into the bloodstream. The most common tracer is FDG, a sugar-like substance. Since cancer cells often use more sugar than normal cells, they absorb more of the tracer and show up as bright spots in the image. PET/CT combines PET with CT (computed tomography) in one scan. PET shows how the body is working (functional information), while CT shows detailed images of the body's structure (anatomical information). Together, PET/CT helps doctors see both the location and activity of tumors or other diseases, making it especially useful in cancer diagnosis, staging, and monitoring.

Similarly, in general oncology, TNM staging (tumor, node, metastasis) is often used for determining disease extent and guiding treatment decisions. While PET/CT is commonly used for whole-body staging, it involves ionizing radiation and often requires radiotracers such as FDG. APTw MRI could offer a radiation-free alternative that provides both anatomical and molecular information, potentially replacing or complementing PET imaging in certain scenarios.

To enable such applications, however, there is a need for technical innovations that allow APTw imaging to be extended to multi-regional or whole-body assessments, while maintaining diagnostic image quality and quantification reliability.

Despite the growing clinical interest in amide proton transfer weighted (APTw) and chemical exchange saturation transfer (CEST) MRI, their application is currently limited to individual body regions. A key challenge lies in the lack of any established technique that enables whole-body APTw/CEST imaging within a clinically acceptable acquisition time.

Given the high cost and limited availability of whole-body PET imaging, a reliable and widely accessible whole-body APTw/CEST alternative would be highly desirable. However, no current method effectively addresses the complex challenges of achieving consistent image quality across multiple anatomical regions in a time-efficient manner.

### SUMMARY OF THE INVENTION

Therefore, it is an object of the invention to provide a method and system for performing whole-body APTw/CEST MRI that enables reliable, time-efficient, and spatially consistent imaging across multiple body regions.

According to the invention, this object is addressed by the subject matter of the independent claims. Embodiments of the invention are described in the dependent claims.

Therefore, according to the invention, a method of performing whole-body (WB) amide proton transfer weighted or chemical exchange saturation transfer (APTw/CEST) magnetic resonance imaging (MRI) is disclosed, the method comprising:
S1) B0 magnetic field shimming for B0 magnetic field homogenization and B1 radiofrequency field shimming for B1 radiofrequency field homogenization at multiple body positions and/or multiple imaging stations,
S2) measuring data including coil sensitivity, resonance frequency, B0 magnetic field maps, and B1 radiofrequency field maps at multiple body positions and/or multiple imaging stations,
S3) adapting a sequence operation protocol for the APTw/CEST locally at multiple body positions and/or multiple imaging stations, based at least in part on the measured data,
S4) acquiring APTw/CEST MRI data at multiple body positions and/or multiple imaging stations on the basis of the adapted sequence operation protocol,
S5) processing the acquired APTw/CEST MRI data for visualization, and
S6) visualizing the processed APTw/CEST MRI data.

In whole-body MRI, the term "station" refers to a specific section of the body that is imaged separately during the scan. Because the MRI scanner can only cover a limited area at once, the patient is scanned in multiple parts, moving through the scanner step by step. Each of these parts is called an imaging station. For example, one station might include the head and neck, the next the chest, then the abdomen, and so on down to the legs. The body is divided into these stations to allow detailed imaging of the entire body piece by piece. In the proposed method, the MRI system may perform a calibration and analysis individually for each station. This includes checking the magnetic field conditions, assessing physiological motion in that region, and analyzing fat content. Based on this information, the imaging protocol may be adapted locally for each station to enhance image quality and reduce artifacts. Using this station-based approach makes it possible to perform advanced whole-body APTw/CEST imaging, even though different parts of the body have different challenges, such as motion or varying tissue composition.

The invention provides a method and system for performing whole-body APTw/CEST magnetic resonance imaging (MRI) in a way that is both clinically feasible and diagnostically reliable across multiple regions of the body. It enables rapid B0 and B1 field homogenization (shimming) at different body positions or imaging stations, ensuring consistent magnetic and RF field conditions throughout the body. This is essential for acquiring high-quality APTw/CEST contrast, especially in regions with anatomical variability or magnetic susceptibility differences. Overall, the invention enables whole-body APTw/CEST imaging suitable for oncological applications, such as assessing primary tumors, lymph nodes, and metastases. It offers a non-invasive, radiation-free alternative to whole-body PET imaging, which is particularly valuable in settings where PET is unavailable or impractical, and allows safe, repeatable longitudinal monitoring.

The multiple body positions and/or multiple imaging stations may be the same for each method step.

According to an embodiment of the invention, in step S2, also fat fraction maps, local physiological motion patterns and/or relaxation maps (e.g., T1) are measured.

According to an embodiment of the invention, in step S2), the measured data also comprises fat content, fat composition and/or motion-related data at multiple body positions and/or multiple imaging stations. This additional information may play an important role in enhancing the APTw/CEST imaging process. Fat signals can interfere with the APTw/CEST contrast and reduce image quality, especially in body regions with high or variable fat content, such as the abdomen, breast, or liver. By measuring the fat content and its spatial distribution, the MRI system can adapt the imaging sequence accordingly - for example, by applying fat suppression techniques, adjusting the spectral sampling scheme, or using water-fat separation methods like Dixon imaging. This leads to cleaner APTw/CEST contrast and better separation between tissue types. In addition, motion-related data may help to account for physiological movements such as breathing or cardiac activity, which can otherwise introduce artifacts or blur the APTw/CEST signal. By identifying regions affected by motion, the system can apply motion compensation strategies such as respiratory or cardiac gating, triggering, or motion-corrected reconstruction. This is especially important in the chest and abdomen, where physiological motion is unavoidable.

According to an embodiment of the invention, in step S3), adapting the sequence operation is performed using at least one of the following methods: parameter adaptations, motion compensation techniques and data adjustments for local post-processing, for example depending on the fat content and/ or fat composition in the region of interest. According to this embodiment, the adaptation of the APTw/CEST sequence operation in step S3) is performed using specific techniques tailored to the conditions at each imaging station. Motion compensation techniques - such as respiratory gating, triggering, or retrospective correction - can be selectively applied in regions affected by physiological motion (e.g., thorax or abdomen), while skipped in more stable regions like the brain or legs. This selective use may improve efficiency while maintaining image quality. It is possible to only apply complex and potentially less scan time efficient compensation strategies to stations affected by physiological motion or fat, while keeping potentially faster techniques for other stations. Data adjustments for post-processing, such as separating water and fat signals or correcting for fat-related background effects, may further enhance the reliability of the APTw/CEST signal. In areas with mixed tissue composition (e.g., liver with partial fat content), such corrections may be helpful for meaningful interpretation.

According to an embodiment of the invention, in step S4), acquiring the APTw/CEST MRI data is performed for multiple Z-spectral offset frequencies. This means that the MRI system applies radiofrequency saturation pulses at several different saturation frequency offsets relative to the water resonance and measures the resulting signal changes. The function of acquiring data at multiple offsets is to generate a so-called Z-spectrum. This spectrum is essential for distinguishing the specific APTw signal from other background effects, such as direct water saturation, magnetization transfer, or signals from fat and other metabolites. A basic method to derive APTw/CEST signals is asymmetry analysis (MTR_{asym}) based on the Z-spectrum. By sampling the Z-spectrum at a larger number of frequency points, it may become possible to apply advanced post-processing techniques, such as background fitting, or multi-pool modeling. These may allow for more accurate and specific quantification of the APTw effect, for example as a biomarker for protein content, tissue pH, or malignancy. The advantage of this embodiment is that it may improve the diagnostic reliability of the APTw/CEST imaging. It may allow the system to separate the true APTw contrast from confounding signals, adapt to local tissue properties, and generate quantitative maps that are consistent across the whole body. Although this approach is more time-consuming than acquiring a single offset, it may provide richer and more robust information - particularly important for applications in oncology, where subtle contrast differences may indicate disease.

According to an embodiment of the invention, in step S4), acquiring the APTw/CEST MRI data is performed using at least one of the following acceleration methods: compressed sensing (CS-SENSE), compressed sensing supported by artificial intelligence (CS-AI), denoising (including AI-based techniques), super-resolution (including AI-based techniques), and Z-spectral acceleration techniques, including data sharing among Z-spectral points, compressed sensing in the Z-spectral dimension, partial Z-spectral scanning, combination of saturation B1rms variation and reduced Z-spectral scanning. In this embodiment, the APTw/CEST MRI data in step S4) is acquired using one or more acceleration methods to reduce the total scan time while maintaining high image quality. This is particularly important for whole-body imaging, where multiple anatomical regions and many Z-spectral offset frequencies must be captured. Without acceleration, such a scan might take too long to be practical in clinical routine.

CS-SENSE combines compressed sensing and parallel imaging to reduce the amount of raw data needed by exploiting signal sparsity and coil sensitivity profiles. CS-AI applies similar principles but uses artificial intelligence (AI) for more efficient and accurate image reconstruction from undersampled data. Denoising techniques, including AI based variants, help improve image quality by reducing noise, which allows faster acquisitions or fewer averages to be used. Super-resolution methods, including AI based variants, reconstruct high-resolution images from low-resolution input data, making it possible to scan faster at lower resolution and recover fine detail afterward.

Additional acceleration may be achieved specifically in the spectral dimension. For example, data can be shared among adjacent Z-spectral frequency points, or the number of frequency offsets can be reduced by applying compressed sensing directly in the Z-spectrum. In some cases, only part of the Z-spectrum is acquired - such as only the positive frequency offsets - and the rest is predicted using model-based or AI-based reconstruction. Another option is to vary the saturation power (B1rms) instead of acquiring many different frequency offsets, which can encode similar contrast information in less time. AI can then be used to extract the relevant APTw signal characteristics, such as pool size or exchange rate.

According to an embodiment of the invention, in step S5), processing the acquired APTw/CEST MRI data for visualization is performed using at least one of the following methods: multi-planar reformatting (MPR), rescaling, including rescaling for fluid suppression, spillover correction, relaxation correction (e.g., based on T1 relaxation maps) or fat masking, and CEST-contrast adapted projections, including 3D to 2D projections. According to this embodiment, the APTw/CEST MRI data acquired in step S4) is processed in step S5) using specific techniques that prepare the data for efficient and meaningful visualization. Since whole-body APTw/CEST imaging produces a large and complex dataset, effective processing is essential to support clinical interpretation and reduce the time required for image review.

One method is multi-planar reformatting (MPR), where the three-dimensional data is reformatted into other viewing planes, such as coronal or sagittal views, even if the original acquisition was in the transverse plane. This allows radiologists to assess anatomical structures and potential findings from different angles and in clinically familiar orientations. Another method is rescaling, which adjusts the intensity of the APTw/CEST contrast to highlight relevant signal changes. For example, fluid suppression can be applied to reduce the visibility of fluid-rich tissues that are not of diagnostic interest, allowing the more subtle APTw signal changes in solid tissues to stand out more clearly. As a further example, spillover correction may be applied to correct APTw signals for underestimation in tissues with strong magnetization transfer effects.

CEST-contrast adapted projections are another possible technique. In this case, the three-dimensional APTw/CEST data is projected into two-dimensional images, similarly to how maximum intensity projections (MIPs) are used in CT or diffusion-weighted MRI. However, instead of simply projecting the highest signal, the projection can be adapted to specific value ranges of the APTw/CEST contrast. This allows areas with signal characteristics of interest, such as suspicious lesions, to be selectively visualized while suppressing background noise or irrelevant signals.

These processing techniques may help to reduce the complexity of the data and focus attention on the clinically relevant regions. They support faster and more intuitive interpretation of the whole-body scan, may improve diagnostic confidence, and may enable the radiologist to quickly identify abnormal findings across multiple body regions. By tailoring the visualization to the contrast characteristics of APTw/CEST data, these methods may make the information more accessible and usable in daily clinical practice.

According to an embodiment of the invention, at least part of the B0 magnetic field and/or B1 radiofrequency field homogenization in step S1) is performed using image-based shim calculation. This means that the system uses fast MRI scans to directly measure the magnetic and RF field distribution in the body and then calculates the shim settings based on these images. Unlike traditional shimming methods that rely on time-consuming, iterative enhancing procedures, image-based shimming may provide a faster and more reproducible approach.

The image-based shim calculation can also be supported by a deep learning model. In this case, a trained neural network analyzes the acquired field maps and predicts the appropriate shim settings, such as adjustments to the gradient coils or RF transmit amplitudes and phases. This allows the system to respond intelligently and rapidly to patient-specific field inhomogeneities, which are especially relevant in whole-body imaging where magnetic and RF field conditions can vary significantly between different anatomical regions. The neural network used for supporting image-based shim calculation has been trained on a dataset comprising B0 and B1 field maps acquired from a large number of subjects across various anatomical regions and body types. The training data includes corresponding ground truth shim settings that were either determined through image-based calculations or obtained using validated simulation models. By learning the relationship between spatial field inhomogeneities and the corresponding good shim parameters, the neural network can predict suitable shim settings for new patients quickly and accurately, even in the presence of anatomical variability.

The main advantage of this embodiment is the significant reduction in calibration time, which contributes to an overall shorter and more efficient examination. In addition, it may improve the consistency and quality of the field homogenization, even in anatomically complex or challenging regions. This leads to more uniform APTw/CEST contrast across the body, reduced artifacts, and more reliable quantification of the imaging signal. The use of deep learning further may enhance robustness by incorporating prior knowledge from large datasets, allowing for high-quality shim estimation even under poor conditions or in cases with limited signal quality. Overall, this embodiment may support faster, more accurate, and patient-specific preparation of the MRI system, enabling high-quality whole-body APTw/CEST imaging in routine clinical use.

According to an embodiment of the invention, a resonance frequency reference F0 is kept constant or recorded per station, such that APTw/CEST Z-spectral data is aligned with B0 map data at multiple body positions. This may be advantageous because the resonance frequency of water can vary slightly across different regions of the body due to local magnetic field inhomogeneities, patient anatomy, or changes in the scanner environment during the examination. By ensuring that the reference frequency F0 is known and consistent - or at least traceable - at each station, the system can accurately align the acquired Z-spectrum with the local B0 field conditions. This allows for better interpretation and correction of the APTw/CEST signal, especially when applying B0-based corrections or calculating metrics like the magnetization transfer asymmetry. Without this alignment, small frequency shifts could lead to incorrect signal attribution, contrast degradation, or misleading quantification. The advantage of this embodiment is that it may improve the reliability and comparability of APTw/CEST data across different parts of the body. It may ensure that the spectral analysis is based on a consistent frequency reference, even when the patient table moves or when separate scans are performed at different body stations. This may lead to more accurate contrast values, better reproducibility, and more reliable detection of pathological changes throughout the body. In the context of whole-body imaging, where subtle spectral shifts can vary across anatomical regions, maintaining or tracking the reference frequency may be essential for consistent image quality and clinical interpretation.

According to an embodiment of the invention, the physiological motion data in step S2) is obtained using at least one of: respiratory belt, radar sensor, camera-based motion tracking, pilot tone sensor, MR-based self-navigation, and external ECG/VCG signals. These tools may provide real-time or near-real-time information about the patient's breathing and cardiac motion, which are the main sources of image-degrading motion artifacts in MRI, especially in regions like the chest and abdomen. By capturing this motion information during the scan, the MRI system can either adapt the sequence in real time - for example by triggering data acquisition at the most stable phase of the breathing or heartbeat - or use the data afterward to retrospectively correct motion-related artifacts. This is particularly valuable in APTw/CEST imaging, where long saturation times and multi-offset acquisitions are especially sensitive to motion. The advantage of this embodiment is that it may enable a more stable and reliable APTw/CEST imaging in body regions that are prone to movement. It may help maintain image sharpness, reduces blurring or signal distortion, and may ensure better alignment of spectral data. Using a variety of sensing options also may increase flexibility, so the most suitable or available method may be selected based on the clinical setup or patient condition.

According to an embodiment of the invention, in step S4), motion-compensated or motion-triggered acquisition of APTw/CEST MRI data is performed, wherein data sampling and optionally contrast preparation is timed to coincide with a phase of minimal motion, such as end-expiration in the breathing cycle or diastole in the cardiac cycle. This approach takes advantage of the motion information obtained earlier in the scan to identify the most stable moments during breathing or heartbeat when the body or internal organs are relatively still. By synchronizing the data acquisition with these low-motion phases, the MRI system may reduce motion artifacts that would otherwise degrade image quality. This is especially important in APTw/CEST imaging, where the contrast is highly sensitive to small motion-related changes, and where signal consistency across multiple frequency offsets is crucial. Motion during acquisition could lead to signal blurring, spectral misalignment, or incorrect quantification. In addition, also the contrast preparation by the RF saturation pulses may be synchronized with low-motion phases, as motion induced global or local resonance frequency (F0) changes may compromise the Z-spectral acquisition. Alternatively, the motion effects on F0 can be pre-recorded during step S2 and incorporated in the post-processing by using a motion state specific B0 correction of the Z-spectrum. The advantage of this embodiment is that it may improve the robustness and accuracy of the APTw/CEST data in regions affected by motion, such as the thorax, upper abdomen, or heart. It may allow for higher image quality without requiring the patient to hold their breath or remain completely still for long periods. This makes the method more patient-friendly, more reliable across different clinical situations, and especially valuable in whole-body imaging, where motion conditions vary depending on the anatomical region. Overall, timing the acquisition and/or contrast preparation to coincide with minimal motion phases may help ensure consistent, high-quality APTw/CEST imaging across the entire body.

According to an embodiment of the invention, in step S5) or S6), the visualization includes superimposing APTw/CEST contrast onto other MRI contrasts, including diffusion-weighted imaging, DWI, and displaying the result as color overlays, multi-planar views, and/or intensity projections. The combined information is then displayed as color overlays, multi-planar views, or intensity projections. This means that the molecular or biochemical information from APTw/CEST imaging is visually integrated with structural or functional data from other MRI sequences, enabling a more comprehensive interpretation. By overlaying APTw/CEST contrast on top of DWI, for example, regions with restricted diffusion - which may indicate tumors or inflammation - may be evaluated together with metabolic or microenvironmental information provided by APTw signals. This fusion of data may enhance lesion characterization and may support better differentiation between benign and malignant findings. Showing the combined data in color overlays helps highlight relevant areas directly, while multi-planar views and projections give radiologists the flexibility to inspect findings in different orientations and to maintain the overview of the whole-body scan. The advantage of this embodiment is that it may improve diagnostic accuracy and efficiency by presenting multiple relevant pieces of information in a single, easy-to-read image. It may reduce the need to mentally correlate findings across separate image series and may help identify clinically significant lesions that might not be as obvious in one modality alone. This may especially be useful in oncology, where precise localization, characterization, and staging of tumors are essential. The combination of APTw/CEST and other MRI contrasts may support a more confident and informed diagnostic decision.

According to an embodiment of the invention, in step S4), the APTw/CEST MRI data is acquired using a reduced number of Z-spectral offsets and reconstructed using a deep learning model to estimate APTw contrast values. Instead of performing a full Z-spectrum acquisition with many frequency offsets - which is time-consuming - only a smaller subset of frequencies is measured. A trained neural network then estimates the APTw contrast information based on the acquired data and additional input, such as field maps or anatomical context. The function of this approach is to shorten the scan time while still providing reliable and quantitative APTw imaging results. The deep learning model has been trained on fully sampled reference data and can accurately infer the shape of the Z-spectrum and extract relevant contrast values, such as APTw signal strength or even parameters like exchange rate or pH. This may enable the system to bypass the need for full-spectrum acquisitions in every station, which may be advantageous in whole-body imaging. The main advantage of this embodiment is the combination of speed and accuracy. It may allow whole-body APTw/CEST scans to be performed in a fraction of the time otherwise required, making the method more suitable for clinical routine. At the same time, the use of deep learning may ensure that the reconstructed data retains diagnostic value and can be interpreted reliably. This also may reduce patient burden, may lower the chance of motion artifacts, and may make the overall examination more efficient. By reducing the data acquisition requirements while maintaining image quality and contrast accuracy, this embodiment may be important for enabling practical, high-quality whole-body APTw/CEST imaging.

According to an embodiment, fast combined calibration sequences are used to acquire B0/B1 field maps and auxiliary data (e.g., fat content, coil sensitivity) in a time-synchronized and spatially consistent manner, improving accuracy and reducing calibration time.

In an embodiment, the spatial volume used for B0 shimming is dynamically adapted for each imaging station based on anatomical region, expected inhomogeneity, or field map analysis.

In one embodiment, the system differentiates between highly motion-sensitive, less motion-sensitive and motion-insensitive periods of the sequence (e.g., RF saturation vs. data sampling vs. delay times) to optimize timing under specific absorption rate (SAR) and relaxation constraints, allowing more flexible motion compensation strategies.

According to one embodiment, instead of sampling multiple frequency offsets, APTw contrast is encoded using B1rms variation, from which the exchange rate or pH is estimated, for example using a trained deep learning model. The deep learning model used for estimating exchange rate or pH from B1rms-varied APTw data is trained on datasets that include APTw/CEST signal responses acquired at different B1rms saturation amplitudes, together with corresponding reference values for exchange rate or pH. These reference values may be obtained from full Z-spectral acquisitions, multi-pool model fitting, pH calibration phantoms, or prior knowledge from clinical or preclinical studies. The training data covers a wide range of tissue types, field inhomogeneities (B0, B1), fat content, and physiological conditions to ensure robust performance in real-world imaging scenarios. The model learns to associate patterns in the signal evolution across B1rms levels with the underlying exchange dynamics, enabling fast, reliable reconstruction of quantitative maps from a reduced set of input data.

In an embodiment, only the positive side of the Z-spectrum is acquired (half-Z), and the complete APTw signal is reconstructed using a deep learning (DL) model trained to infer asymmetry or pool parameters, thereby reducing acquisition time and simplifying fat-related correction requirements.

In a further embodiment, motion impact is estimated using deep learning models applied to static overview images, allowing motion-compensated protocol adaptation without requiring dynamic motion sensing. The deep learning model used to estimate motion impact from static overview images is trained on datasets that include anatomical MRI scans, such as Dixon-type or low-resolution whole-body overview images, along with corresponding dynamic motion data acquired from sensors (e.g., respiratory belts, ECG, radar, pilot tone) or from motion-resolved MR acquisitions (e.g., self-navigation, navigators). The training data spans various body regions, patient positions, and breathing or cardiac patterns to capture the diversity of physiological motion encountered in clinical practice. During training, the model learns to associate static anatomical features - such as diaphragm position, body contour, or organ proximity to motion sources - with expected motion amplitude and pattern in those regions. Once trained, the model can predict local motion impact (e.g., likelihood and magnitude of respiratory or cardiac motion, likelihood and magnitude of F0 changes) from a single static overview scan, enabling automatic protocol adaptation for motion-prone regions without the need for real-time motion tracking during the actual APTw/CEST scan.

The invention also relates to a magnetic resonance imaging (MRI) system configured for performing whole-body (WB) amide proton transfer weighted or chemical exchange saturation transfer (APTw/CEST) MRI, the system comprising:
a magnetic resonance imaging unit with a scanner bore and a patient table movable through the scanner bore in steps or continuously, and
a controller configured to:
   perform B0 magnetic field and B1 radiofrequency field homogenization at multiple imaging stations,
   acquire per-station data including coil sensitivity, resonance frequency, B0 map, and B1 map,
   determine motion-related data and fat content and/or composition per imaging station;
   locally adapt the sequence operation protocol for APTw/CEST imaging per station based on the acquired data,
   acquire APTw/CEST MRI data at multiple imaging stations using accelerated acquisition techniques,
   process and visualize the acquired data using adapted visualization techniques including any of multi-planar reformatting, rescaling, contrast-based projections, fusion with other MRI contrasts.

Embodiments of this MRI system correspond analogously to the previously described embodiments of the method according to the invention.

The invention also relates to a computer program product comprising instructions which, when the program is executed by a computer, causes the computer to control an MRI system and to carry out the steps of any of the method embodiments according to the invention.

The invention also relates to computer-readable medium having stored thereon the aforementioned computer program product.

### BRIEF DESCRIPTION OF THE DRAWINGS

The enclosed drawings disclose preferred embodiments of the present invention. It should be understood, however, that the drawings are for the purpose of illustration only and not as a definition of the limits of the invention.

In the drawings:
Fig. 1 schematically depicts a magnetic imaging resonance system according to an embodiment of the invention, and
Fig. 2 illustrates a flowchart of a method according to an embodiment of the invention.

### DETAILED DESCRIPTION OF EMBODIMENTS

For the purposes of promoting and understanding the principles of the present disclosure, reference will now be made to the embodiments illustrated in the drawings, and specific language will be used to describe the same. It is nevertheless understood that no limitation to the scope of the disclosure is intended. Any alterations and further modifications to the described devices, systems, and methods, and any further application of the principles of the present disclosure are fully contemplated and included within the present disclosure as would normally occur to one skilled in the art to which the disclosure relates. In particular, it is fully contemplated that the features, components, and/or steps described with respect to one embodiment may be combined with the features, components, and/or steps described with respect to other embodiments of the present disclosure. For the sake of brevity, however, the numerous iterations of these combinations will not be described separately. Features described in relation to a system, may be implemented in a computer implemented method and/or in a computer program product, in a corresponding manner.

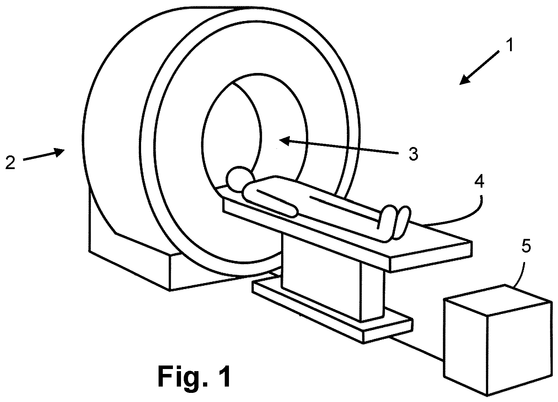

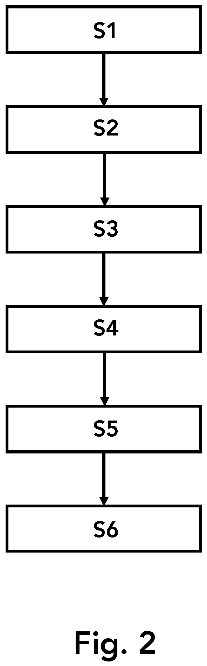

Fig. 1 schematically illustrates a magnetic resonance imaging (MRI) system according to an embodiment of the invention. The MRI system 1 comprises a magnetic resonance imaging unit 2 with a scanner bore 3 and a patient table 4 that can be moved through the scanner bore 3 either stepwise or continuously. The system further includes a controller 5, which is configured to execute the method according to an embodiment of the invention, as outlined in the flowchart shown in Fig. 2.

The method according to this embodiment is directed to perform whole-body (WB) amide proton transfer weighted or chemical exchange saturation transfer (APTw/CEST) magnetic resonance imaging in a time-efficient and diagnostically reliable manner across multiple body regions.

In step S1, B0 magnetic field shimming for static magnetic field homogenization and B1 radiofrequency field shimming for transmit field homogenization are performed at multiple body positions and/or imaging stations. At least part of this field homogenization is carried out using image-based shim calculation, which allows for fast, reproducible estimation of optimal shim settings based on acquired B0 and B1 maps. These shim settings may be determined directly or predicted using a trained deep learning model, which enables robust adjustment even in complex anatomical regions and contributes to improved homogeneity and contrast uniformity throughout the whole body.

In step S2, the system measures technical and physiological auxiliary data at multiple body positions or imaging stations. This includes coil sensitivity information, local resonance frequency, B0 and B1 maps, as well as additional data such as fat content, fat composition, and motion-related information. These parameters are essential for adapting the imaging protocol to region-specific conditions. For instance, measuring fat content may help identify areas that require fat suppression or fat-water separation to avoid confounding signals in the Z-spectrum, particularly in fat-rich organs such as the liver, breast, or abdomen. Motion information is acquired using one or more of the following sensing techniques: respiratory belt, radar sensor, camera-based tracking, pilot tone sensor, MR-based self-navigation, external electrocardiography (ECG), vectorcardiography (VCG) signals. These techniques provide real-time or predictive insights into patient motion and support further steps of motion-adapted acquisition.

In step S3, the APTw or CEST imaging sequence is adapted locally for each station or table position based on the measured data from step S2. Adaptations may for example include changes in sequence parameters, motion compensation techniques, or data adjustments for post-processing, such as spectral sampling strategies tailored to fat content or B0 variation. This regional adaptation may improve the robustness and diagnostic quality of the scan, particularly in areas affected by motion or field inhomogeneity.

In step S4, the APTw or CEST MRI data is acquired at multiple imaging stations using the locally adapted sequence protocol. The acquisition includes multiple Z-spectral offset frequencies, which allows for the generation of Z-spectra that are essential for extracting accurate APTw contrast. To maintain a clinically acceptable total scan time, the acquisition is accelerated using one or more of the following techniques: compressed sensing combined with parallel imaging (CS-SENSE), deep learning-supported compressed sensing (CS-AI), denoising, super-resolution, and Z-spectral acceleration methods, including data sharing among spectral points, compressed sensing in the spectral domain, partial Z-spectral acquisition, and the combination of B1rms variation with reduced spectral sampling. These methods reduce acquisition time while preserving spatial and spectral resolution. In this step, the system may also perform motion-compensated or motion-triggered acquisition, whereby data sampling and optionally also contrast preparation (RF saturation) is synchronized with phases of small physiological motion, such as end-expiration or cardiac diastole. This targeted timing minimizes motion-related artifacts, ensures spectral consistency, and improves image sharpness without requiring the patient to hold their breath or remain completely still.

Further, the APTw or CEST MRI data may be acquired using a reduced number of Z-spectral offsets, and the missing spectral information is reconstructed using a deep learning model. This model has been trained on complete reference datasets and is capable of reliably estimating contrast values such as APTw signal strength, exchange rate, or pH. This approach further shortens the acquisition time while maintaining diagnostic quality.

In step S5, the acquired APTw or CEST MRI data is processed for visualization. This includes multi-planar reformatting (MPR), enabling radiologists to inspect anatomical regions in various planes; rescaling, such as fluid suppression, which enhances contrast visibility; and CEST-contrast adapted projections, including 3D-to-2D transformations that highlight signal patterns of interest (e.g., signal ranges associated with malignancy). These visualization techniques reduce complexity and enhance interpretability of the large datasets typically generated in whole-body APTw or CEST scans.

In step S6, the processed data is visualized for diagnostic interpretation. In this step, or alternatively in step S5, the APTw or CEST contrast may be superimposed onto other MRI contrasts, such as diffusion-weighted imaging (DWI), and displayed as color overlays, multi-planar views, or intensity projections. This fusion of biochemical and structural and/or functional data enhances lesion characterization and may improve diagnostic confidence, especially in oncological applications where tumor metabolism and cellularity both play critical roles.

In this embodiment, a resonance frequency reference F0 is either kept constant or recorded per imaging station, ensuring that the APTw or CEST Z-spectral data is correctly aligned with the B0 map. This alignment supports accurate correction and quantification, especially when the magnetic field varies between stations.

Altogether, the system illustrated in Fig. 1, and the method shown in Fig. 2, provide a comprehensive and integrated approach for performing whole-body APTw or CEST MRI with high spatial and spectral consistency, efficient scan times, and clinically usable data quality across a wide range of anatomical regions.

The invention enables reliable, time-efficient, and spatially consistent whole-body APTw or CEST MRI and is applicable in a variety of diagnostic and clinical settings. One example of implementation is a whole-body APTw or CEST acquisition based on a multi-station fast spin-echo sequence. In this example, nine Z-spectral points are acquired at seven different saturation offset frequencies. An integrated overview scan and calibration are performed in a single automated run, updating coil sensitivity calibration, B0 shimming, and B1 shimming (including adaptive calibration of two transmission channels) for each table position. During the APTw scan, three Z-spectral acquisitions at +3.5 ppm are used to update the current B0 field map per station. This may ensure reliable alignment of the Z-spectra with the local magnetic field. The B0 shimming volume is dynamically adjusted per table position to control field homogeneity locally. Compressed sensing with an overall acceleration factor of R = 4 is used to keep scan times within clinically acceptable limits while preserving image quality.

In this example, the acquisition parameters are as follows: a 3D multi-shot fast-spin echo sequence is used across two stations, each covering 26 coronal slices with a field of view (FOV) of 365 × 400 × 200 mm³ and a voxel size of 2.9 × 3 × 8 mm³. The scan uses centric k-space ordering with TR/TE = 5600/7 ms, flip angle α = 90°, refocusing flip angle α_ref = 125°, and driven equilibrium to improve image contrast and SNR. The Z-spectral step size is 0.8 ppm, saturation power B1rms = 1.5 µT, and saturation time Tsat = 2.0 s. For fat-water separation at +3.5 ppm, a 3-echo Dixon approach is used with an echo shift of 0.4 ms. The total scan time is approximately 2 × 4:20 minutes for two stations.

Beyond this specific implementation, the invention can be applied broadly in multiple clinical domains, which may be any of the following nonlimiting examples.

Whole-body applications of CEST-based contrast: this method is not limited to amide proton transfer (APTw) but can also be applied to other endogenous CEST contrasts, such as hydroxyl CEST or amine CEST, which reflect tissue composition and pH. In addition, exogenous CEST contrast agents, such as glucose-based or glucosamine-based agents, can also be used with the same whole-body acquisition framework. The system can be adapted to control saturation and readout parameters depending on the molecular target and spectral profile of the chosen contrast mechanism.

Whole-body, contrast-agent-free tumor and metastasis screening: APTw/CEST provides molecular sensitivity to protein content and pH changes, which are often altered in tumors. This enables a non-invasive, radiation-free alternative to PET/CT for tumor detection and follow-up. The method allows the simultaneous assessment of multiple body regions for the presence of primary tumors or distant metastases in a single scan session.

Whole-body TNM staging: this method supports comprehensive oncological staging by enabling high-resolution imaging of the primary tumor (T), regional lymph nodes (N), and potential distant metastases (M) throughout the body. This is of particular relevance in malignancies where the disease burden is not limited to a single anatomical site and where longitudinal monitoring is required.

Systemic disease assessment: this method is highly suitable for evaluating systemic diseases characterized by changes in protein concentration or tissue pH. Examples include autoimmune disorders, chronic inflammatory diseases, and metabolic syndromes. Endogenous CEST-based pH mapping or the use of exogenous agents like Iopamidol (as used in AcidoCEST) can be integrated into the same acquisition protocol, enabling organ-wide or system-wide assessment of biochemical imbalances.

Neurofibromatosis and tumor predisposition syndromes: the ability to detect and characterize tumors throughout the body, including benign and potentially malignant peripheral nerve sheath tumors, makes this method highly useful for monitoring patients with neurofibromatosis (NF1, NF2) or other tumor predisposition syndromes. These patients often require repeat imaging at multiple body locations over time, which the method supports efficiently and without radiation exposure.

Research and drug monitoring: the method may also be applied in preclinical or clinical research to monitor changes in tissue metabolism, tumor microenvironment, or treatment response. For example, serial APTw or CEST imaging can detect early biochemical changes in tumor tissue following chemotherapy, targeted therapy, or immunotherapy - potentially before morphological changes become visible.

In all these applications, the combination of spatially resolved molecular imaging, accelerated acquisition techniques, motion compensation, and advanced visualization allows APTw/CEST MRI to extend beyond single-organ use into robust, clinically relevant whole-body imaging. The method reduces reliance on PET or contrast-enhanced CT, minimizes patient exposure to radiation or exogenous agents, and provides new diagnostic information that complements conventional MRI.

It is understood that one or more of the aforementioned embodiments of the invention may be combined as long as the combined embodiments are not mutually exclusive.

While the invention has been illustrated and described in detail in the drawings and foregoing description, such illustration and description are to be considered illustrative or exemplary and not restrictive; the invention is not limited to the disclosed embodiments. Other variations to the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to our advantage. Any reference signs in the claims should not be construed as limiting the scope. Further, for the sake of clearness, not all elements in the drawings may have been supplied with reference signs.

## Claims

1. A method of performing whole-body chemical exchange saturation transfer, CEST, magnetic resonance imaging, MRI, the method comprising:
S1) B0 magnetic field shimming for B0 magnetic field homogenization and B1 radiofrequency field shimming for B1 radiofrequency field homogenization at multiple body positions and/or multiple imaging stations,
S2) measuring data including coil sensitivity, resonance frequency, B0 magnetic field maps, and B1 radiofrequency field maps at multiple body positions and/or multiple imaging stations,
S3) adapting a sequence operation protocol for the CEST MRI locally at multiple body positions and/or multiple imaging stations, based at least in part on the measured data,
S4) acquiring CEST MRI data at multiple body positions and/or multiple imaging stations on the basis of the adapted sequence operation protocol,
S5) processing the acquired CEST MRI data for visualization, and
S6) visualizing the processed CEST MRI data.

2. The method of claim 1, wherein measuring data comprises measuring any of: fat content, fat composition and/or motion-related data at multiple body positions and/or multiple imaging stations.

3. The method according to any one of the previous claims, wherein adapting the sequence operation is performed using at least one of the following methods: parameter adaptations, motion compensation techniques and data adjustments for local post-processing.

4. The method according to any one of the previous claims, wherein acquiring the CEST MRI data is performed for multiple Z-spectral offset frequencies.

5. The method according to any one of the previous claims, wherein acquiring the CEST MRI data is performed using at least one of the following acceleration methods: CS-SENSE, CS-AI, denoising, super-resolution, and Z-spectral acceleration techniques, including data sharing among Z-spectral points, compressed sensing in the Z-spectral dimension, partial Z-spectral scanning, combination of saturation B1rms variation and reduced Z-spectral scanning.

6. The method according to any one of the previous claims, wherein processing the acquired CEST MRI data for visualization is performed using at least one of the following methods: multi-planar reformatting, MPR, rescaling, including rescaling for fluid suppression, spillover correction, relaxation correction, fat masking, and CEST-contrast adapted projections including 3D to 2D projections.

7. The method according to any one of the previous claims, wherein at least part of the B0 magnetic field and/or B1 radiofrequency field homogenization is performed using image-based shim calculation.

8. The method according to any one of the previous claims, wherein a resonance frequency reference F0 is kept constant or recorded per station, such that CEST Z-spectral data is aligned with B0 map data at multiple body positions.

9. The method according to any one of the previous claims, wherein measuring data comprises measuring physiological motion data obtained using at least one of: respiratory belt, radar sensor, camera-based motion tracking, pilot tone sensor, magnetic resonance-based self-navigation, external electrocardiography and vectorcardiography signals.

10. The method according to any one of the previous claims, wherein acquiring CEST MRI data comprises motion-compensated or motion-triggered acquisition, and wherein data sampling is timed to coincide with a phase of minimal motion.

11. The method according to any one of the previous claims, wherein visualizing the processed CEST MRI data includes at least one of: multi-planar reformatting, rescaling, contrast-based projections, fusion with other MRI contrasts, superimposing CEST contrast onto other MRI contrasts, including diffusion-weighted imaging, and displaying the result as color overlays, multi-planar views, and/or intensity projections.

12. The method according to any one of the previous claims, wherein acquiring CEST MRI data comprises acquiring CEST MRI data using a reduced number of Z-spectral offsets and reconstructed using a deep learning model to estimate CEST contrast values.

13. The method according to any one of the previous claims wherein the CEST MRI is amide proton transfer weighted, APTw, MRI, and the CEST contrast is APTw contrast.

14. A magnetic resonance imaging, MRI, system (1) configured for performing whole-body chemical exchange saturation transfer, CEST, MRI, the system (1) comprising:
a magnetic resonance imaging unit (2) with a scanner bore (3) and a patient table (4) movable through the scanner bore (3), and
a controller (5) configured to perform a method according to any one of claims 1 to 13.

15. A computer program product comprising instructions which, when the program is executed by a computer, causes the computer to control a magnetic resonance system according to claim 14 to carry out a method according to any one of claims 1 to 13.
